# EUROPEAN PATENT APPLICATION

(11) **EP 3 647 872 A1**
(43) Date of publication of application: **06.05.2020**
(21) Application number: 18203977.6
(22) Date of filing: 01.11.2018
(51) Int. Cl.: G03F 7/20, H05G 2/00

(54) **A METHOD FOR CONTROLLING THE DOSE PROFILE ADJUSTMENT OF A LITHOGRAPHIC APPARATUS**

(71) Applicant: ASML Netherlands B.V., 5500 AH Veldhoven (NL)
(72) Inventor: O GORMAN, Colm, 5500 AH Veldhoven (NL)
(74) Representative: Peters, John Antoine

(57) **Abstract**

Disclosed is a method for controlling a dose profile of a lithographic apparatus along a direction perpendicular to a direction of scanning across a patterning device, the method comprising: determining a parameter associated with an intensity distribution of radiation provided by a source apparatus to an optical input of the lithographic apparatus, wherein the determining of the parameter is at least based on a relation between the condition of the radiation at the optical input of the lithographic apparatus and the dose profile.

## Description

### Field of invention

The invention relates to a method for controlling a dose profile of a lithographic apparatus along a direction perpendicular to a direction of scanning across a patterning device and/or substrate. In particular, but not exclusively, the invention relates to system in which radiated light is provided to a slit-shaped area on the substrate and the dose or intensity profile is controlled dynamically during the scanning of the radiation across the substrate.

### Background

A lithographic apparatus (also referred to as a "scanner") is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-kl lithography may be used to process features with dimensions smaller than the classical resolution limit of a lithographic apparatus. In such process, the resolution formula may be expressed as CD = k1×λ/NA, where λ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Methods to produce EUV light include, but are not necessarily limited to, converting a material into a plasma state that has at least one element, e.g., xenon, lithium or tin, with one or more emission line in the EUV range. In one such method, often termed laser produced plasma ("LPP") the required plasma can be produced by irradiating a target material having the required line-emitting element, with an excitation source in the form of a laser beam.

One particular LPP technique involves irradiating a target material droplet with one or more pre-pulse(s) followed by a main pulse. In this regard, CO2 lasers may present certain advantages as a drive laser producing "main" pulses in an LPP process. This may be especially true for certain target materials such as molten tin droplets. For example, one advantage may include the ability to produce a relatively high conversion efficiency e.g., the ratio of output EUV in-band power to drive laser input power.

In more theoretical terms, LPP light sources generate EUV radiation by depositing laser energy into a source element, such as xenon (Xe), tin (Sn) or lithium (Li), creating a highly ionized plasma with electron temperatures of several 10's of eV, The energetic radiation generated during de-excitation and recombination of these ions is emitted from the plasma in all directions. In one common arrangement, a near-normal-incidence mirror (often termed a "collector mirror") is positioned at a distance from the plasma to collect, direct (and in some arrangements, focus) the light to an intermediate location, e.g., focal point. The collected light may then be relayed from the intermediate location to a set of scanner optics and ultimately to a wafer. In more quantitative terms, one arrangement that is currently being developed with the goal of producing about 100 W at the intermediate location contemplates the use of a pulsed, focused 10-12 kW CO2 drive laser which is synchronized with a droplet generator to sequentially irradiate about 40,000-100,000 tin droplets per second. For a typical LPP setup, target material droplets are generated and then travel within a vacuum chamber to an irradiation site where they are irradiated, e.g. by a focused laser beam.

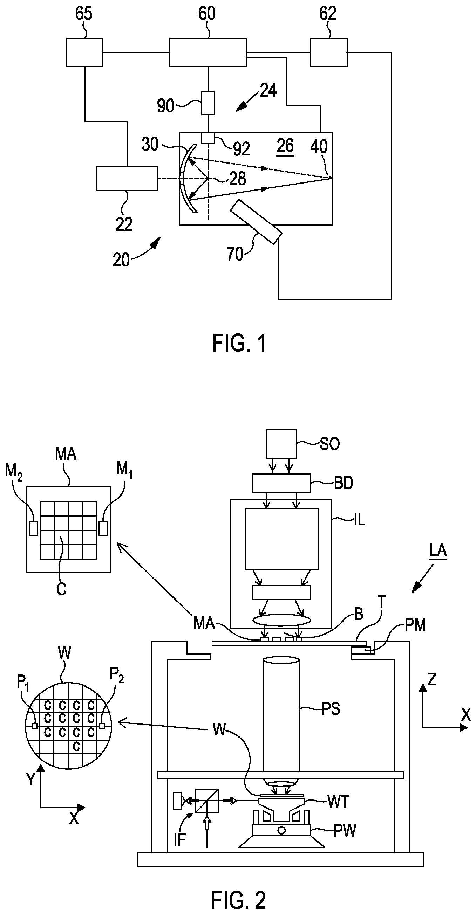

With initial reference to Figure 1, there is shown a schematic view of an EUV light source, e.g., a laser-produced-plasma. The LPP light source 20 may include a pulsed laser system 22 for generating a train of light pulses and delivering the light pulses into a chamber 26. Each light pulse may travel along a beam path from the system 22 and into the chamber 26 to illuminate a respective target droplet at an irradiation region 28.

Suitable lasers for use as the system 22 shown in FIG. 1 may include a pulsed laser device, e.g., a pulsed gas discharge CO2 laser device producing radiation at 9.3µm or 10.6 µm, e.g., with DC or RF excitation, operating at relatively high power, e.g., 10 kW or higher and high pulse repetition rate, e.g., 50 kHz or more. In one particular implementation, the laser may be an axial-flow RF-pumped CO2 laser having a MOPA configuration with multiple stages of amplification and having a seed pulse that is initiated by a Q-switched Master Oscillator (MO) with low energy and high repetition rate, e.g., capable of 100 kHz operation. From the MO, the laser pulse may then be amplified, shaped, and/or focused before entering the LPP chamber.

Depending on the application, other types of lasers may also be suitable, e.g., an excimer or molecular fluorine laser operating at high power and high pulse repetition rate. Examples include, a solid state laser, e.g., having a fibre or disk shaped active media, an excimer laser having one or more chambers, e.g., an oscillator chamber and one or more amplifying chambers (with the amplifying chambers in parallel or in series), a master oscillator/power oscillator (MOPO) arrangement, a power oscillator/power amplifier (POPA) arrangement, or a solid state laser that seeds one or more excimer or molecular fluorine amplifier or oscillator chambers, may be suitable. Other designs are possible.

As further shown in Figure 1, the EUV light source 20 may also include a target material delivery system 24, e.g., delivering droplets of a target material into the interior of a chamber 26 to the irradiation region 28 where the droplets will interact with one or more light pulses, e.g., zero, one or more pre-pulses and thereafter one or more main pulses, to ultimately produce a plasma and generate an EUV emission. The target material may include, but is not necessarily limited to, a material that includes tin, lithium, xenon, gadolinium, terbium or combinations thereof. The EUV emitting element, e.g., tin, lithium, xenon, gadolinium, terbium, etc., may be in the form of liquid droplets and/or solid particles contained within liquid droplets. For example, the element tin may be used as pure tin, as a tin compound, e.g., SnBr4, SnBr2, SnH4, as a tin alloy, e.g., tin-gallium alloys, tin-indium alloys, tin-indium-gallium alloys, or a combination thereof. Depending on the material used, the target material may be presented to the irradiation region 28 at various temperatures including room temperature or near room temperature (e.g., tin alloys, SnBr4) at an elevated temperature, (e.g., pure tin) or at temperatures below room temperature, (e.g., SnH4), and in some cases, can be relatively volatile, e.g., SnBr4.

Continuing with Figure 1, the EUV light source 20 may also include an optic 30, e.g., a collector mirror in the form of a truncated ellipsoid having, e.g., a graded multi-layer coating with alternating layers of Molybdenum and Silicon. FIG. 1 shows that the optic 30 may be formed with an aperture to allow the light pulses generated by the system 22 to pass through and reach the irradiation region 28. As shown, the optic 30 may be, e.g., an ellipsoidal mirror that has a first focus within or near the irradiation region 28, and a second focus at a so-called intermediate region 40, where the EUV light may be output from the EUV light source 20 and input to a device utilizing EUV light, e.g., an integrated circuit lithography tool (not shown). It is to be appreciated that other optics may be used in place of the ellipsoidal mirror for collecting and directing light to an intermediate location for subsequent delivery to a device utilizing EUV light, for example, the optic may be parabolic or may be configured to deliver a beam having a ring-shaped cross-section to an intermediate location.

Continuing with reference to FIG. 1, the EUV light source 20 may also include an EUV controller 60, which may also include a firing control system 65 for triggering one or more lamps and/or laser devices in the system 22 to thereby generate light pulses for delivery into the chamber 26. The EUV light source 20 may also include a droplet position detection system which may include one or more droplet imagers 70 that provide an output indicative of the position of one or more droplets, e.g., relative to the irradiation region 28. The imager(s) 70 may provide this output to a droplet position detection feedback system 62, which can, e.g., compute a droplet position and trajectory, from which a droplet error can be computed, e.g., on a droplet-by-droplet basis, or on average. The droplet error may then be provided as an input to the controller 60, which can, for example, provide a position, direction and/or timing correction signal to the system 22 to control a source timing circuit and/or to control a beam position and shaping system, e.g., to change the location and/or focal power of the light pulses being delivered to the irradiation region 28 in the chamber 26.

The EUV light source 20 may include one or more EUV metrology instruments for measuring various properties of the EUV light generated by the source 20. These properties may include, for example, intensity (e.g., total intensity or intensity within a particular spectral band), spectral bandwidth, polarization, beam position, pointing, etc. For the EUV light source 20, the instrument(s) may be configured to operate while the downstream tool, e.g., photolithography scanner, is-on-line, e.g., by sampling a portion of the EUV output, e.g., using a pickoff mirror or sampling "uncollected" EUV light, and/or may operate while the downstream tool, e.g., photolithography scanner, is off-line, for example, by measuring the entire EUV output of the EUV light source 20.

As further shown in FIG. 1, the EUV light source 20 may include a droplet control system 90, operable in response to a signal (which, in some implementations may include the droplet error described above, or some quantity derived therefrom) from the controller 60, to e.g., modify the release point of the target material from a droplet source 92 and/or modify droplet formation timing, to correct for errors in the droplets arriving at the desired irradiation region 28 and/or synchronize the generation of droplets with the pulsed laser system 22.

### Summary

The present invention provides a method and apparatus according to the appended claims.

Disclosed herein is a method for controlling a dose or intensity profile of a lithographic apparatus along a direction perpendicular to a direction of scanning across a patterning device, the method comprising: determining a parameter associated with an intensity distribution of radiation provided by a source apparatus to an optical input of the lithographic apparatus, wherein the determining of the parameter is at least based on a relation between the intensity distribution of the radiation at the optical input of the lithographic apparatus and the dose or intensity profile.

The source apparatus may comprise a plasma light source in which a plurality of droplets of a material are converted in turn into a plasma to radiate light using an irradiation source. In such a case, the method may further comprise: adjusting the parameter to irradiate the plurality of droplets so as to produce a desired dose profile along a direction perpendicular to the direction of scanning.

The method may further comprise: irradiating the plurality of droplets along a first irradiation axis in turn with the irradiation source to provide a plurality of disc droplets; and, irradiating the plurality of disc droplets in turn along a second irradiation axis to provide a plasma and resultant radiant light.

The parameter may relate to the position of the second irradiation axis relative to the position of the each of the plurality of disc droplets such that each of the plurality of disc droplets is irradiated along the second irradiation axis at an off-centre position of the disc droplets.

Each disc droplet may be tilted with respect to the second irradiation axis such that light radiated from the plasma has an intensity distribution to provide the desired dose profile.

The tilt of the each disc droplet may be provided by irradiating each of the plurality of droplets along the first irradiation axis, wherein the first irradiation axis is tangentially inclined with respect to the droplet surface, the tangential inclination being predetermined to provide a desired dose profile.

The plurality of droplets may be passed in series through the first irradiation axis along a path of travel and the tangential inclination is provided by irradiating the droplet at a predetermined position along the path of travel and the parameter relates to the irradiation to droplet position.

The first irradiation axis may be fixed and the parameter is the timing of the irradiation relative to the droplet position.
The first irradiation axis may be moveable and the parameter is the position of the irradiation axis relative to the droplet position.

The patterning device may be predetermined to include higher dose areas and lower dose areas, and the dose profile may be adjusted using the parameter to provide the higher dose areas and lower dose areas respectively.

The radiation may be provided to a slit which extends in the direction perpendicular to the direction of scanning. The parameter may be adjusted whilst the slit is moved across the patterning device in the direction of scanning.

The parameter may be adjusted to provide a predetermined dose profile for the scan.

The parameter may be adjusted once for a series of the plurality of droplets, wherein the series is greater than two.

The intensity of the irradiating source may be determined in accordance with the angle of incidence.

The angle of tilt may be between plus or minus 5 degrees that of a nominal angle of tilt which provides a symmetric dose profile. The nominal angle of tilt may be between minus 25 degrees and plus 15 degrees.

The second irradiation axis may be plus or minus 10 microns that of a nominal droplet centre which provides a nominal dose profile at the time of irradiation.

The irradiation source may comprise at least one laser. The irradiation source may comprise a first laser beam and a second laser beam.

The radiant light may be EUV. The droplet material may comprise tin.

The plurality of droplets may be provided at a frequency of between 40kHz and 100kHz.

The source apparatus may provide an optical output having an off-centre intensity distribution.

The lithographic apparatus may include one or more moveable blocking element arranged to block and/or filter a portion of the dose profile or intensity profile.

The method may further comprise: providing a patterning device; providing a substrate for exposure in the lithographic apparatus; providing radiation from the source apparatus to the optical input of the lithographic apparatus in which the parameter has been adjusted to provide a predetermined dose profile associated with the patterning device; exposing the substrate to radiation from the source apparatus according to the predetermined dose profile.

Exposing the substrate to radiation may comprise scanning the substrate in a first direction and the method further comprises: adjusting the parameter during the scan in the first direction.

The method may further comprise: providing a second patterning device for exposing a further substrate within the lithographical apparatus; adjusting the parameter to provide a predetermined dose profile associated with the second patterning device.

A source apparatus may comprise a laser, and the parameter may relate to a beam pointing characteristic. A lithography apparatus may be a Deep UV apparatus.

The method may further comprise: providing a configuration file for use by the lithographic apparatus or source apparatus, wherein the configuration file comprises at least one predetermined parameter setting associated with a lithographic apparatus or source apparatus.

Also described herein is a lithographic apparatus comprising: a source apparatus for providing radiation to an optical input of the lithographic apparatus, wherein the lithographic apparatus is configured to scan the radiation across a patterning device in a direction of scanning, wherein the radiation has a dose profile along a direction perpendicular to the direction of scanning; and a processor configured to adjust a parameter associated with the source apparatus according to any of method claims 1 to 27 to adjust the dose profile.

Also described herein is a computer program comprising instructions which, when executed on at least one processor, cause the at least one processor to control an apparatus to carry out any or part of the methods and method steps described herein.

Also described herein is a carrier containing the above recited computer program. The carrier may be one of an electronic signal, optical signal, radio signal, or non-transitory computer readable storage medium.

Also described herein is a method for controlling a dose profile of a lithographic apparatus along a direction perpendicular to a direction of scanning across a patterning device, the method comprising: determining a parameter associated with an intensity distribution of radiation provided by a source apparatus to an optical input of the lithographic apparatus wherein the parameter is determined at least partially based on a relation between the parameter and a characteristic of the radiation at an image and/or object plane of the lithographic apparatus.

The method may further comprise: monitoring the intensity distribution of radiation at the image and/or object plane of the lithographic apparatus.

The parameter may be a parameter of the lithographic apparatus.

The lithographic apparatus may comprise a tiltable membrane which is configurable to alter the intensity distribution, wherein the parameter relates to the angle of tilt of the tiltable membrane.

Also described herein is a method for controlling a dose profile of a lithographic apparatus along a direction perpendicular to a direction of scanning across a patterning device, the method comprising: determining a parameter associated with an intensity distribution of radiation provided by a laser produced plasma light source apparatus to an optical input of the lithographic apparatus, wherein the parameter adjusts the laser to droplet position within the source apparatus to provide an off-centre intensity distribution in the direction perpendicular to the direction of scanning.

The parameter may be related to the timing of a pre-pulse laser.

Also described herein is a method for controlling a dose profile of a lithographic apparatus along a direction perpendicular to a direction of scanning across a patterning device, the method comprising: determining a parameter associated with an intensity distribution of radiation provided by a source apparatus to an optical input of the lithographic apparatus; scanning the radiation across the patterning device in the direction of scanning; adjusting the parameter during the scan.

Also disclosed herein is a method for controlling a dose profile across an exposure field of a lithographic apparatus, the method comprising: controlling the dose profile based on selecting an exposure field specific setting of a control parameter associated with a source providing radiation to the lithographic apparatus.

Also disclosed herein is a source apparatus for providing radiation to a lithographic apparatus, wherein the source apparatus is configured to receive one or more settings of a parameter associated with a dose profile of the radiation, wherein the one or more settings are based on the parameter as determined using any of the methods or method steps described herein. The one or more settings of the parameter may provide an off-centre dose profile.

Also described herein is a lithographic apparatus having an optical interface arranged to receive a radiation output from the source apparatus, wherein the radiation output has a far-field asymmetric intensity distribution. The optical interface may convert the intensity distribution into a slit having an off-centre dose profile or intensity profile.

The skilled person will appreciate that except where mutually exclusive, a feature described in relation to any one of the aspects described herein may be applied mutatis mutandis to any other aspect or example. Furthermore except where mutually exclusive any feature described herein may be applied to any aspect and/or combined with any other feature described herein.

### Brief Overview of Figures

The invention will now be described, by way of example only, with reference to the accompanying drawings, in which:
Embodiments of the invention will now be described, by way of example only, with reference to the accompanying schematic drawings, in which:
Figure 1 depicts a schematic view of an EUV light source;
Figure 2 depicts a schematic overview of a lithographic apparatus;
Figure 3 depicts a schematic overview of a lithographic cell;
Figure 4 depicts a schematic representation of holistic lithography, representing a cooperation between three key technologies to optimize semiconductor manufacturing;
Figure 5 depicts a flow diagram indicating the steps in a method for controlling the dose profile for a lithographic apparatus;
Figure 6 depicts a schematic representation of droplets within a laser produced plasma light source;
Figure 7 depicts the tilt angles of disc droplets within the laser produced plasma light source of Figure 6;
Figure 8 depicts a representation of the pre-pulse firing position and resultant disc droplet orientation;
Figure 9 depicts a radiation distribution of EUV light caused by different pre-pulse firing positions;
Figure 9a shows various parameters relating to an EUV source apparatus;
Figure 10 depicts a 2D dose profile is shown in plan;
Figure 11 depicts an alternative 2D dose profile in plan.

### Detailed description

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The description of the method within this specification is predominantly related to an EUV light source and, in particular, a laser produced plasma, an example of which is provided in relation to Figure 1. However, this is not limiting and the source of electromagnetic radiation may be provided by other means. For example, the electromagnetic radiation may be DUV.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

Figure 2 schematically depicts a lithographic apparatus LA. The lithographic apparatus LA includes an illumination system (also referred to as illuminator) IL configured to condition a radiation beam B (e.g. DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The radiation source may also be referred to as a source apparatus and may take the form of the light source shown in Figure 1. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

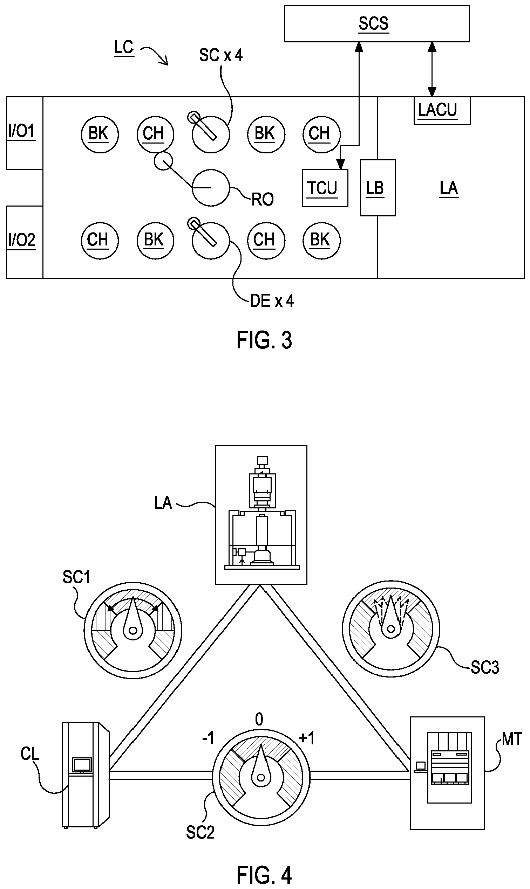

As shown in Figure 3, the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 4. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 4 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 4 by the multiple arrows in the third scale SC3).

Described herein is a method for controlling and providing a dose profile or an intensity profile of a lithographic apparatus LA. The method may comprise: determining a parameter associated with an intensity distribution of radiation provided by a source apparatus 20 to an optical input of the lithographic apparatus LA. Determining the parameter may be at least based on a relation between the condition of the radiation at the optical input of the lithographic apparatus LA and the dose profile or an intensity profile.

It will be appreciated that where dose profile is referred to, this may also be considered to mean the intensity profile, where applicable. The dose profile and intensity profile be considered relative to the patterning device or substrate. The intensity distribution of the radiation may be a spatial or angular distribution.

The dose profile or an intensity profile may be dynamically adjustable during a scan. Further, the dose profile or an intensity profile may have a peak intensity which is off-centre with regard to the direction perpendicular to a direction of scanning across a patterning device.

In one example, the direction perpendicular to the direction of scanning across a patterning device (the scan direction) may be defined by a slit. The slit may have a centre and the dose profile or an intensity profile may have a peak intensity which is off-centre with regards to the centre, or a central portion, of the slit. As such the dose profile may be considered to be asymmetric. The parameter may be determined to purposely provide an off-centre peak or asymmetric profile rather than the peak being off-centre within the normal operating envelope of the source apparatus or lithographic apparatus.

It will be appreciated that although lithographic apparatuses typically provide radiation in a direction which is perpendicular to the scan direction, e.g. via a slit, perpendicular should not be taken to be limiting the arrangement to being strictly perpendicular and non-right-angled arrangements are also considered to be covered by the term perpendicular. In other words, the dose profile may be controlled at least in a direction which is perpendicular to the scanning direction. This is in contrast to some known lithographic apparatuses which control the intensity along the direction of scanning.

Dose profile may be taken to mean the intensity distribution of the light provided at an input to the lithographic apparatus, at an image, or at an object plane within the lithographic apparatus. For example, the input may be the input of the beam delivery system BD or the illumination system IL described in relation to Figure 2.

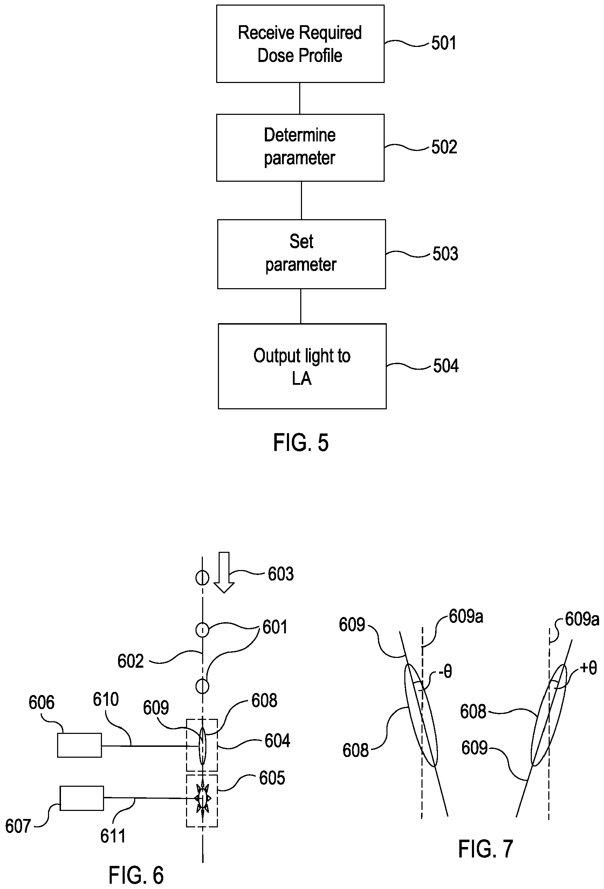

Figure 5 provides a flow diagram showing steps which may be included in a method for controlling a dose profile of a lithographic apparatus along a direction perpendicular to a direction of scanning across a patterning device.

The first step comprises receiving a required dose profile 501. The received dose profile may be predetermined in accordance with a particular fabrication process. The fabrication process may stipulate a patterning device (or IC design) which requires a particular dose profile for a particular application. The dose profile may be received, for example, as part of instructions for controlling the source apparatus 20 as part of a predetermined fabrication recipe. Additionally or alternatively, the dose profile may be determined during an exposure and in response to metrological data. The instructions may form part of a configuration file provided to either the source apparatus 20 or lithographic apparatus, or be determined by one or more computer programmes operating within or in connection with lithographic apparatus LA or source apparatus 20.

In step 502, the parameter is determined. The determination of the parameter will be dependent on which parameter is to be adjusted. In one example, the parameter relates to a laser to droplet position. The laser to droplet position may be taken to mean the relative position of the laser with respect to the droplet when the laser is fired. Thus, the parameter may relate specifically to the timing of a laser pulse which is used to energise a droplet of material. Alternatively, or additionally, the parameter may relate to the position of the laser pulse relative to a droplet travel axis along which the droplets travel prior to being energised. A further exemplary parameter may relate to the feed of the droplet along a travel axis, such as the timing of the droplet release.

Other examples of parameters may exist. For example, the source apparatus 20 may comprise a Deep UV light source. In this case, the parameter may relate to the beam pointing of a laser within a DUV source apparatus. The beam pointing may be adjusted to provide an off-centre peak, or adjusted during a scan such that different dose profiles are provided at different points in the scan direction. Another exemplary apparatus may include a membrane which is tiltable to provide an asymmetric radiation distribution. Hence, the parameter may relate to the angle of tilt of the membrane. The membrane may form part of a filter. The filter may be spectral purity filter.

In step 503, the determined parameter may be set by, for example, providing the parameter to the controller 60 so that the controller 60 makes the necessary adjustment to the source apparatus 20 or components thereof. It will be appreciated that the parameter may be a generic parameter and include one or more sub-parameters or different control parameters.

In step 504, light radiated from the source apparatus is provided to the input of the lithographic apparatus LA.

Any of the steps 501 to 502 may be repeated a plurality of times during an exposure of a patterned device or substrate. For example, the dose profile may be determined in real time as an exposure scan of the patterning device is carried out. Further, the parameter may change such that a first parameter is varied during a scan and a second parameter is adjusted during the scan. For example, a first parameter may relate to the laser to droplet position, with a second parameter relating to the intensity of the laser or the adjustment of beam shaping components. This may be useful, for example, where the conversion efficiency is reduced due to the displacement of the droplet and the intensity needs to be increased to compensate for this. Further optimisations for the loss if EUV may be carried out by moving the position of the laser relative to droplet, altering the pre-pulse to main pulse delay.

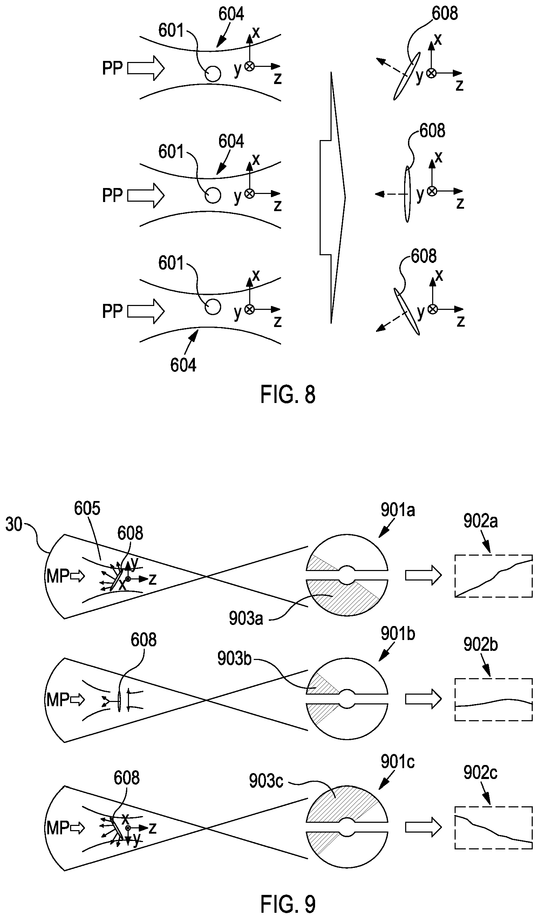

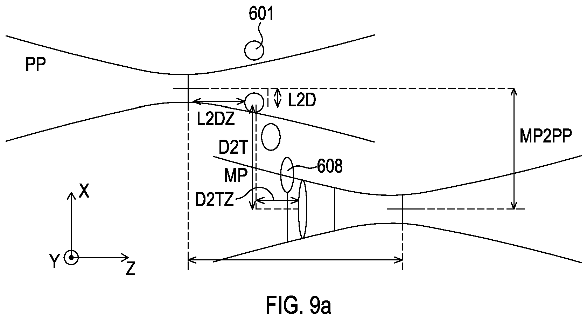

Figure 9 a shows various parameters which may be determine, and in some instances be controlled to change, the EUV radiation pattern from the droplets. In Figure 9a, PP is the pre-pulse laser, or pre-pulse radiation zone; L2D is the laser to droplet position which relates to the pre-pulse focus to droplet distance; D2T is the droplet to target position which relates to the distance between the droplet to target distance. MP2PP is the main pulse to pre-pulse position which relates to the distance between the main pulse focus and the pre-pulse focus positions. Finally, MP2T is the main pulse focus to target position.

For each of the parameters there exists an x direction in the droplet train position, and a z direction which is along the laser optical axis. Thus, D2TX and D2TZ are the relative position in the x and z directions as shown.

A change in the laser to droplet position in the x direction may cause a change in the alignment of the target to the main pulse and a change in the target expansion, as well as the change in target angle. This may cause a change in the radiated EUV. This change in the radiated EUV may be accounted for by dynamically varying a parameter relating to the laser to droplet position in the z direction. Additionally or alternatively, the change in the radiated EUV could be accounted for by dynamically varying a parameter relating to the pre pulse laser beam energy. Thus, changing the target expansion rate back to nominal at the changed laser to droplet position value. Additionally or alternatively, the change in EUV could be accounted for by dynamically varying a parameter relating to the main pulse to pre-pulse delay. Thus, ensuring that the target to main pulse alignment is back to nominal at the changed laser to droplet position value. In some examples, the system may comprise a movable pre-pulse box, in which case some EUV could be recovered by adjusting the pre-pulse box position to retain the main pulse to target position.

During a scan, the radiation beam does not irradiate an entire patterning device MA simultaneously with a blanket or flood exposure, but instead scans across the patterning device MA to expose the pattern gradually. This mode of operation may be referred to as the scan or a scan mode. One way of achieving a scan is to provide the electromagnetic radiation having a slit profile to the patterning device MA in which the slit profile is swept broadside across the patterning device. A way to control a dose or intensity profile of a lithographic apparatus along a direction perpendicular to a direction of scanning across a patterning device may relate to dynamic adjustment of a beam pointing parameter associated with a Deep UV source apparatus at an optical input of the lithographic apparatus.

The size and shape of a slit may be varied using beam shaping techniques and methods as known in the art. One or both of mechanical (e.g. beam block) and optical (e.g. beam shaping optics) methods and tools may be used to shape the beam to define the slit. The exposure slit area may be located in a plane in the radiation beam path, which may be a conjugate plane to the plane of the patterning device MA. A beam block located in the exposure slit area may be used to define the slit size and shape, blocking away areas of the beam so that only a portion of the beam cross-section, with a slit of a desired shape and size is obtained at the patterning device. The beam block may comprise one or more blades, which may be movable in and out of at least a portion of the path of the radiation beam so as to block or unblock a portion of the radiation beam. The beam block may be located in a conjugate plane of the patterning device MA for a radiation beam, so that adjustments to the shape of the beam are translated to the slit in the plane of the patterning device MA.

Other known dose control systems may include a real-time adjustment of the exposure dose in the scanning direction or adjustment of the field to field exposure level across the wafer. Additionally or alternatively, the dose control system may include a moveable filter which may be used local to the patterning device and alter the slit transmission to provide tilt. The filter may be a grey filter and may be positionable to provide a desired additional profile control, as known in the art. Exemplary control systems are described in US5986742 and "Etch, Reticle, and track CD Fingerprint Corrections with Local Dose Compensation", van der Laan, Hans, et al. Proceedings of SPIE Col. 5575 pages 107 to 118, which are incorporated herein by reference.

Alternatively or additionally, beam shaping optics may be used to set the shape and size of the beam. The exposure slit area determining the shape and size of the slit may comprise a three-dimensional region (e.g. a region containing the components of the beam shaping optics) along a portion of the propagation path of the radiation beam. Compared to beam blocks, beam shaping optics have an advantage that they do not block parts of the power of the radiation beam.

The shape and size of the slit may be determined in an exposure slit area. Specifically, the exposure slit area may be used to determine the length of the slit. The exposure slit area may be located between the source of the radiation beam and the patterning device MA. Beam shaping actions affecting properties other than the slit length may be performed inside and/or outside the exposure slit area. Alternatively or additionally, radiation beam shaping may be performed after the radiation beam passes through the pattering device MA. The resulting slit shape may include for example a square shape, a rectangular shape, or a trapezoidal shape. The size of the slit along the non-scanning direction in the plane of the patterning device may be of the order of cm, for example 3 cm. The slit length may be in the order of mm, for example 1 mm - 10 mm, or 1 mm - 20mm. Required control of the slit length may be in the order of mm, for example selection of a slit length between 1 and 20 mm,. Setting of the slit length may have a resolution in the order of 1 mm, or 0.1 mm.

Scanning the radiation beam across the patterning device, may be achieved by keeping the radiation beam stationary and moving the patterning device MA relative to the beam. The substrate is moved synchronously with the patterning device MA. Synchronized movement of patterning device MA and substrate W may take into account properties of the projection system PS, such as, for example, (de)magnification and/or image reversal.

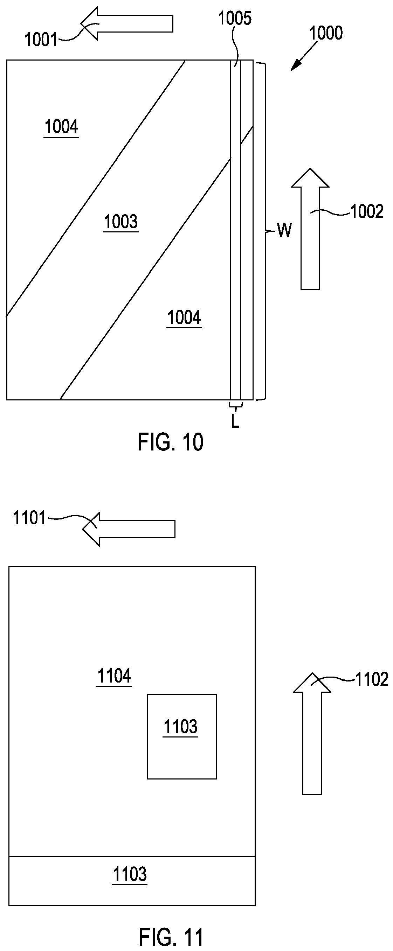

The scanning may be performed in a first direction, which may be a linear direction. The dose profile may be controlled in a second direction which is perpendicular to the first direction. The second direction may be referred to as the dose profile direction. The radiation beam may extend to cover the entire dimension of the patterning device MA in the second direction. The size and shape of a cross-section of the beam in a plane of the patterning device, when incident on the patterning device MA, may be referred to as a slit of radiation beam. The slit may be elongate, i.e. longer than it is wider, having a longitudinal axis. The slit may be a straight line slit having a width W across the patterning device and a length L along the patterning device in the scan direction to provide a letterbox or rectangular shaped profile against the patterning device or substrate as shown in Figure 10. The first direction may correspond to the longitudinal axis of the exposure slit.

The slit will have a dose profile. The dose profile may be defined by an intensity distribution along the width of the slit. The intensity distribution may be centrally disposed so as to have a peak intensity within a central region, or a skewed or off-centre peak intensity in which the peak intensity is located to one side or the other of the central region. The off-centre peak intensity dose profile may be referred to as an asymmetric dose profile. It will be appreciated that the normal variance within a 'centred' dose profile may be marginally asymmetric whilst the profile is broadly symmetrical. A significant difference with the off-centre dose profile of the invention is that it is determined to be off-centre/asymmetric, rather than being accidentally or parasitically off-centre.

As per Figure 1, the source apparatus 20 may comprise a plasma light source in which a plurality of droplets of a material are converted, in turn, into a plasma to radiate light using an irradiation source, such as one or more lasers. In such a case, the condition of the radiation at the optical input of the lithographic apparatus LA upon which the parameter is determined may be the intensity distribution of the radiation. As such, the method may further comprise: adjusting the parameter to irradiate the plurality of droplets so as to produce a desired dose profile along a direction perpendicular to the direction of scanning, e.g. along the slit.

The method may include irradiating the plurality of droplets, in turn, along a first irradiation axis, with the irradiation source to provide a plurality of disc droplets; and, irradiating the plurality of disc droplets in turn along a second irradiation axis to provide a plasma and resultant radiant light. Each disc droplet may be tilted with respect to the second irradiation axis (or travel axis) such that light radiated from the plasma and collected for delivery to the input of the lithography input has an intensity distribution to provide the desired dose profile. Alternatively, or additionally, the main pulse laser to droplet position may be altered to provide the main pulse at an off-centre location of the droplet. This may also provide a axisymmetric or off-centre far field intensity distribution or dose profile/intensity profile.

Figure 6 shows a schematic representation of droplets 601 falling along a travel axis 602. The droplets 601 may be produced in any suitable way such as that described in US8158960, which is incorporated herein by reference. The source of droplets is represented by arrow 603 which shows the droplets travelling. The droplets may be provided from a target material delivery system 24, as described above in connection with Figure 1.

The droplets 601 pass along the travel axis 602 within a vacuum to a first irradiation region 604 and a second irradiation zone 605. The first irradiation zone 604 corresponds to a location along the droplet path/travel axis 603 at which the droplet undergoes a first irradiation step. The first irradiation step may correspond to irradiation by a pre-pulse laser 606 when the source apparatus comprises a LPP source. The second irradiation region 605 is provided downstream of the first irradiation region 604 and may be provided by a main laser or plasma laser 607 position in which the pre-pulsed droplet 601 is excited into a plasma state which radiates the required light for collection by the collector 30 (shown in Figure 1). The pre-pulse laser 606 and main laser 607 form part of a pulsed laser system 22 and the first irradiation region 604 and second irradiation region 605 may form part of the irradiation region 28, described in relation to Figure 1 above.

The method of generating the plasma light source when using a droplet 601 may be achieved in two stages. The first stage may involve generating a plurality of disc droplets 608 in which the individual droplets passing along the travel axis are irradiated by a first excitation source, typically the pre-pulse laser 606. The pre-pulse laser 606 energises the spherical droplets into a shape which can be broadly described as a disc or pancake shape which is shown in transverse section in Figure 6. The disc droplets 608 will typically have opposing face surfaces on either side of a central plane 609, which as shown lies along the travel axis 602. The opposing faces terminate at the peripheral edges of the disc droplet 608. The peripheral edges of the disc droplet 608 may lie in the central plane 609. The disc droplet will typically be circular when viewed in the direction normal to the central plane 609 of the disc but other shapes and normal variations may be possible.

Each disc droplet 608 will have an orientation relative to the travel axis 602 and/or first or second irradiation axes 610, 611. The orientation may be determined and/or controlled by the laser to droplet position at the time of pre-pulse firing and the resultant angle at which the laser beam strikes the droplet 601. The orientation may be referred to as the tilt of the disc droplets 608.

The pre-pulse laser beam and plasma laser beam extend along and define the respective first 610 and second 611 irradiation axes or pre-pulse and main pulse beam axes. As the droplet 601 travels along the travel axis 602, the first irradiation axis 610 sweeps across the facing surface of the pre-irradiated droplet 601 such that the angle of incidence between the irradiation axis 610 and surface of the droplet changes with time. By controlling the timing of the laser pulse relative to the position of the droplet, that is, the laser to droplet position, the firing angle of the pre-pulse laser beam into the surface of the droplet 601 can be controlled. When the laser 606 is fired this produces a disc droplet 608 which is inclined relative to the travel axis 602 and/or irradiation axes in which the inclination is dependent of the incident firing angle of the pre-pulse laser 606.

In other words, the tilt θ of each disc droplet 608 may be provided and/or controlled by irradiating each of the plurality of droplets 601 along the first irradiation axis 604, wherein the first irradiation axis 610 is tangentially inclined with respect to the droplet surface. The tangential inclination may be predetermined to provide a desired dose profile. The tangential inclination may be provided by the irradiation axis 610 being positioned against the incident surface in a non-radial relation. Thus, the irradiation axis 610 may be inclined to the surface of the droplet. That is, the irradiation may be inclined to the tangent of the droplet 601 surface at the point where the irradiation axis 610 meets the surface of the droplet 601, rather than being aligned with the normal of the tangential plane.

The tangential inclination may be provided by the irradiation axis 610 striking the droplet at point which is separated from the centre of the droplet, so as to be laterally displaced from the centre of the droplet. That is, as the position of the first irradiation axis 610 moves across the lateral extent of a pre-irradiated droplet 601 as the droplet 601 moves along the travel axis 602 and past the first irradiation axis 610 and choosing the lateral position of the irradiation axis 610 when the droplet 601 is irradiated allows the angle of tilt of the disc droplet 608 to be chosen. Hence, a plurality of droplets 601 may be passed in series through the first irradiation axis 610 along the travel axis 602 and the tangential inclination provided by irradiating the droplet at a predetermined droplet position along the path of travel/travel axis 602. The cause of the tilt, i.e. target angle, is understood to be due to the droplet being irradiated with a laser intensity gradient. At the centre of the beam the gradient is substantially flat/even. As the laser strike goes off centre, it is ablated by a laser pulse with a strong gradient. This leads to non-uniform expansion and a tilt/target angle.

The first irradiation axis 610 and second irradiation axis 611 may be parallel to one another or may be inclined to one another. Either or both of the first 610 and second irradiation axis 611 may be orthogonally arranged relative to the travel path.

The disc droplets 608 can be considered to fall in a train along the travel axis 602 from the first irradiation zone 604 to the second irradiation zone 605 with a constant tilt θ. The orientation, i.e. tilt, may be defined by the angle of the central plane 609 of the disc droplets 608 relative to the travel axis 602 above the disc droplet centre, or relative to the nominal central plane 609a which is the position of the central plane 609 required to provide a neutral dose profile having the peak distribution at the centre of the dose profile.

Hence, as shown in Figure 7, the disc droplets 608 may have a negative inclination or tilt -θ (left hand side) or a positive inclination or tilt +θ (right hand side) as determined by the angular separation of the central plane 609 and the nominal central plane 609a.

The disc droplets 608 may have an exposed side which faces the irradiation axes 610, 611 and a shadowed side which faces away from the irradiation axes 610. The disc droplets 608 may be positively inclined such that the exposed side faces (i.e. the normal of the central plane 609 points) upstream of the irradiation axis 611 relative to the direction of travel along the travel axis 602, or negatively inclined such that the exposed side faces downstream of the irradiation axis relative to the travel axis 602. A neutral or nominal position of the disc droplets may be taken to be when the central plane 609 is aligned with the travel axis 602.

It will be appreciated that as well as being inclined relative to the travel axis 602, there is scope for the disc droplets 608 to be provided in different rotational positions relative to the travel axis 602. However, the disc droplets 608 will typically be rotationally aligned such that the normal of the central plane 609 extends parallel to the irradiation axis 611 when viewed along the travel axis 609.

The tilt angle may vary according to the desired dose profile and/or intensity required at the optical input. In some examples, the tilt angle may be between plus or minus 5 degrees that of a nominal tilt angle which provides a broadly centred/symmetric dose profile. It will be appreciated that the plus or minus 5 degrees may include nominal tolerances. The nominal average angle of tilt may be between minus 25 degrees to plus 15 degrees. Larger nominal degrees are possible. For example, the nominal average may be between minus 30 degrees and plus 30 degrees. It will be appreciated that there may be a distribution of a tilt angles within the stream of droplets in accordance with normal operating tolerances. Hence, the average target angle may be considered to fall within the ranges provided.

The lateral position of the first irradiation axis may be between the ranges of +/- 10 microns with respect to the droplet centre.

The laser to droplet positon at the time of firing the pre-pulse laser may be determined by a known relationship. That is, an average predetermined laser to droplet position may provide an average tilt angle over a particular time period. Alternatively of additionally, the laser to droplet position may be controlled by using feedback from elsewhere in the lithographic apparatus. For example, the tilt angle could be measured in line and controlled using one or more sensors. The sensors may be energy sensors. The energy sensors may be located on either side of the reticle at the reticle stage. The two energy sensors may measure a change in their ratio as the tilt is varied. In some examples a change in ratio between the sensors as measured within the source may also be used to control this.

In one example, a slit uniformity tilt, i.e. the tilt of the slit as provided on the wafer, may be rotated by between 0.05% and 0.8% per micron of laser to droplet position movement. In one example, the slit uniformity tilt may be rotated by 0.06% per micron.

The laser to droplet position may be determined using known properties of the system or by observing the dose profile. As noted in relation to Figure 1, the EUV light source 20 may also include an EUV controller 60, which may also include a firing control system 65 for triggering one or more lamps and/or laser devices in the system 22 to thereby generate light pulses for delivery into the chamber 26. The EUV light source 20 may also include a droplet position detection system which may include one or more droplet imagers 70 that provide an output indicative of the position of one or more droplets, e.g., relative to the irradiation region 28. The imager(s) 70 may provide this output to a droplet position detection feedback system 62, which can, e.g., compute a droplet position and trajectory, from which a droplet error can be computed, e.g., on a droplet-by-droplet basis, or on average. The droplet error may then be provided as an input to the controller 60, which can, for example, provide a position, direction and/or timing correction signal to the system 22 to control a source timing circuit and/or to control a beam position and shaping system such that the dose profile can be set up as required.

A method of determining a parameter associated with control of an intensity profile of radiation provided at an optical input of a lithographic apparatus may comprise: determining a parameter setting at least partially based on the effect the setting has on a characteristic of the radiation at an image and/or object plane of the lithographic apparatus LA. The parameter may be set so as to configure the far field intensity at the input of the lithographic apparatus in view of an expected output (dose profile) of the lithographic apparatus LA.

Thus, the parameter and/or a parameter setting may be adjusted to provide a desired radiation distribution at an image and/or object plane or input to the lithographic apparatus LA. The image and/or object plane may be monitored using suitable metrology equipment to provide data relating to the adjustment of the parameter and effect on the radiation distribution. The data may be used as part of a process optimisation model to correct or otherwise adjust the parameter setting.

The setting of the parameter using data captured at the image and/or object plane may be used either where the parameter to be adjusted relates to a source apparatus 20, or where the parameter is associated with a further control device which is independent of the source apparatus 20. The parameter may be associated with the lithographic apparatus. In some examples, the dose profile may be adjusted using a tiltable membrane that can be adjusted to tilt the far field intensity distribution.

The tangential inclination may be provided by irradiating the droplet 601 at a predetermined position along the path of travel 602. In such a case, the parameter associated with an intensity distribution of radiation provided by the source apparatus 20 to the optical input of the lithographic apparatus LA may be the irradiation to droplet position, or laser to droplet position in the case of a laser produced plasma method.

The irradiation to droplet position may be adjusted in one or more of a plurality of ways. A first way may include having the first irradiation axis 610 fixed and adjusting the timing of the irradiation relative to the droplet position. In such a case, the parameter to adjust the dose profile may be the firing time of the pre-pulse laser 606. In another example, the first irradiation axis 610 may be translatable such that it can be moved upstream or downstream relative to the travel axis 602 and irradiation zones 604, 605. In doing so, the irradiation may be provided at constant time intervals with the irradiation axis 610 being translated to provide the variance in the position of the irradiation axis to the droplet surface. As such, the parameter which controls the dose profile may be the position of the irradiation axis relative to the droplet position. It will be appreciated that these two parameters, and others, may be adjusted in conjunction or individually, as required.

Figure 8 shows a representation of the pre-pulse firing position and resultant disc droplet 608 orientation for three different laser to droplet positions. The pre-pulse laser (indicated by PP) shown at the top of the figure is fired in the first irradiation region 604 at a time where the irradiation axis lies above a central portion of the droplet to provide a positive tilt in the disc droplet 608. The middle section of the figure shows the firing of the pre-pulse laser PP at a position within the central region to provide a neutral tilt in which the disc droplet is in-line with travel axis. The bottom portion of the figure shows a firing position in where the irradiation axis incident on the droplet below the central portion which results in a negative tilt.

Referring to Figure 9, there is shown the second irradiation zone 605 and firing of the main pulse laser 607 (indicated as MP) to provide the plasma and radiation of EUV light. The radiated light is collected by a collector 30 which reflects the light towards the input of the lithographic apparatus MA. The effect of the tilt can be seen as providing an asymmetric change in the far field intensity distributions 901a-c for each of the firing positions which results in a dose profile 902a-c when provided into a slit using, for example, the beam shaping techniques described above. The dose profiles 902 represent the intensity on the vertical axis and the slit position of on the horizontal axis.

The top section in Figure 9 shows the main pulse laser MP exciting the disc droplet 608 having a positive tilt. This results in an asymmetric intensity distribution across the far field 901a with non-centralised portion of higher intensity light. The illuminator of the lithographic apparatus transforms the asymmetric intensity distribution 901a to a slit the dose profile 902a having greater intensity at a first end of the slit relative to a second end of the slit. The central region may have an intensity which is between the higher intensity at the first end and the lower intensity at the second end. As shown, the dose profile 902a may have a maximum at the first end edge of the slit and may generally decreases along the width of the slit to a minimum at the second end edge of the slit.

In the middle section of Figure 9, the centralised neutrally aligned disc droplet causes a centralised intensity distribution in the far field 901b. When provided as a slit, the dose profile 902b provides a substantially flat intensity distribution profile which is reasonably uniform. It will be noted that the intensity distribution/dose profile 902b may have a moderate peak intensity which is outside of the central region. However, this is a parasitic peak which may be cancelled out by appropriate monitoring and feedback within either the source apparatus and/or lithographic apparatus. Importantly, the step determining the required control parameter for the centralised intensity profile, did not include determining a parameter in which the intensity profile is off-centre. Rather, it was determined to provide a centralised distribution.

In the bottom section of Figure 9, the main pulse laser MP is shown as exciting the disc droplet 608 with a negative tilt. As with the positive tilt, this results in an asymmetric distribution in the far field 901c with non-centralised portion of higher intensity light. At the slit, the higher intensity region of the dose profile 902c is provided at the second end of the slit, rather than the first as with the positive tilt. Again the central region may have an intensity which is between the higher end value and the lower end value. As shown, the dose profile 902c may have a maximum at the second end edge of the slit and may generally decreases across the width of the slit to a minimum at the first end edge of the slit.

Figure 9 shows dose profiles 902a and 902c in which the extrema of the intensity are located at the extreme positions across the slit. It will be appreciated, that the parameter may be determined to provide the peak intensity at any point across the width of the slit.

The terms non-centred distribution/dose profile or asymmetric distribution/dose profile may be taken to be mean a non-uniform distribution of light intensity along the width of the slit which is biased away from the centre of the slit. The dose profile may include a peak intensity. The peak intensity may be provided between 45% and 55% of the centre point of the slit which may represent a central region of the slit. Where the peak is outside of the central region it may be considered to be a non-centred or asymmetric distribution/dose profile. In one example, the peak of an asymmetric distribution may be provided at between 60% and 100% of the slit width. In another example, the peak of the asymmetric distribution may be provided at between 0% and 40%.

The dose profile may be provided as a static distribution which does not vary for all or a part of a scan. Alternatively, or additionally, the dose profile may have a distribution which varies dynamically by adjusting the parameter associated with the intensity distribution during a scan. Thus, in use, the patterning device may be predetermined to include higher dose areas and lower dose areas, and the dose profile may be adjusted using the parameter to provide the higher dose areas and lower dose areas respectively.

Where the radiation is provided to a slit which extends in the direction perpendicular to the direction of scanning, the parameter may be adjusted whilst the slit is moved across the patterning device in the direction of scanning.

This is illustrated in Figure 10 in which a 2D dose profile 1000 is shown in plan. The scan direction is shown with arrow 1001 and may be taken to be from right to left. The slit direction 1002 is perpendicular to the scan direction 1001 and represents the direction in which the longitudinal axis of the slit extends across the patterning device/wafer which is being exposed. The slit 1005 is represented by the rectangular box. The two-dimensional dose profile includes different areas of intensity distribution. Hence, there may be a higher dosed areas and lower dosed areas in accordance with a predetermined desired profile. In the example of Figure 10, there is a higher dose profile region 1003 which extends diagonally across the patterning device. The higher dose profile is bounded by lower dose profile regions 1004.

The higher dose profile region 1003 may be provided by dynamically adjusting the parameter during the scan. As per the above description, the higher dose profile 1004 may be achieved by adjusting the laser to droplet position during the scan. In the example shown, the scan starts on the right hand side of the patterning device (not shown) with the maximum intensity at a peripheral edge. During the scan, the pre-pulse laser to droplet position is continuously altered by dynamically adjusting the parameter which controls the pre-pulse laser to droplet position, such as the timing of firing the pre-pulse laser. This moves the peak intensity for each scan position until the peak intensity is located at the opposing peripheral edge.

Although a diagonal pattern is shown in Figure 10, it will be appreciated that the dose profile can be adjusted to suit a desired predetermined dose profile for a particular application, as per Figure 11.

Figure 11 shows a 2D dose profile 1100 which is generally similar to that of Figure 10 with reference numerals incremented by 100. In the example of Figure 11, there is a higher dose profile region 1103 which is limited to the central region of the patterning device MA. The higher dose region 1103 may be achieved using the parameter setting methods described above in conjunction with known beam control methods. Other methods may include a dose control system. The dose control system may include a dose per field in which the dose can be adjusted, e.g. offset, for each exposure field in a plurality of dose fields. The dose control system may include a real-time adjustment of the exposure dose in the scanning direction. The dose control system may include a moveable filter which may be used local to the patterning device and alter the slit transmission. The filter may be a grey filter and may be positionable to provide a desired additional profile control, as known in the art. Exemplary control systems are described in US5986742 and "Etch, Reticle, and track CD Fingerprint Corrections with Local Dose Compensation", van der Laan, Hans, et al. Proceedings of SPIE Col. 5575 pages 107 to 118, which are incorporated herein by reference. The higher dose profile may be bounded by lower dose profile regions 1004. Thus, there shown a portion of the higher dose 1103 which is surrounded on at least three sides by a substantially uniform exposure filed. The higher dose profile 1103 may include a distributed dose profile having one or more peak intensity regions.

Other predetermined dose profiles may, for example, include a constant but off-centre dose profile across the slit 1005 for the duration of the scan so as to provide a higher dose along one edge of the scan, as shown by the higher intensity region 1103a along the bottom edge.

The higher and lower intensity regions shown in Figures 10 and 11 are shown as discrete bands. It will be appreciated that this is for ease of explanation only and the distribution of the intensity in a working system will likely have a continuously varying profile along the width of the slot.

The dynamic adjustment of the parameter may be continuous for a scan or carried out in discrete intervals. The continuous adjustment may result in adjacent droplets in a series of droplets having different laser to droplet positions. The discrete adjustment may result in adjacent droplets or a series of adjacent droplets having a common laser to droplet position/firing angle. Thus, the discrete intervals may be determined based on the frequency of the droplets such that the parameter is adjusted once within a series of droplets. For example, the parameter may be adjusted once every four droplets or ten droplets. More generically, for droplet train having period N, the parameter may be adjusted every xN, where x is greater than 2. Hence, the parameter may be adjusted once for a series of the plurality of droplets, wherein the series is greater than two. It will be appreciated that the firing angle is related to the tangential angle between the droplet surface and irradiation axis. Thus, the firing angle is related to the lateral position of the irradiation axis on the incident surface of the droplet, as described above.

Adjusting the parameter in discrete steps/intervals can improve the accuracy of the system by allowing the system to reach a steady state after changing the firing angle. In particular, changing the firing angle/lateral position for each droplet may cause either temporal or positional disruption to the flow of droplets along the travel axis.

When changing the firing angle of the pre-pulse it is possible that the conversion efficiency is altered. The conversion efficiency relates to the conversion of the irradiation source power to radiated light, e.g. the ratio of output EUV in-band power to drive laser input power. Thus, the irradiation source may be adjusted when adjusting the laser to droplet position in accordance with the angle of incidence to provide the required dose intensity for a particular dose profile.

The source element may any suitable material such as xenon (Xe), tin (Sn) or lithium (Li). The source element may be provide in droplet form along the travel axis. The drops may be travel along the travel axis under the force of gravity at a frequency of between 40kHz and 100kHz.

The parameter may be adjusted to suit different patterning devices within a fabrication process or different fabrication steps within a fabrication process. Hence, a first layer of a device for processing may be exposed to a first dose profile using a first patterning device, and a second layer of the same device may be exposed to the same or a different dose profile using the same or a different patterning device.

Hence, in use, an exposure step in a fabrication process may comprise the steps of: providing a patterning device; providing a substrate for exposure in a lithographic apparatus; providing radiation from the source apparatus to the optical input of the lithographic apparatus in which a parameter has been adjusted to provide a predetermined dose profile associated a width of the patterning device; and, exposing the substrate to radiation from the source apparatus according to the predetermined dose profile. In this way, the dose profile can be adjusted from layer to layer and for different patterning devices. The different dose profiles may be altered dynamically during a scan or provide an off-centre peak at a constant location for all or part of the scan. That is, exposing the substrate to radiation may comprise scanning the substrate in a first direction and adjusting the parameter during the scan in the first direction.

The above description is predominantly concerned with the laser to droplet position of the pre-pulse laser. However it will be appreciated that the main laser to droplet position may be altered whilst keeping the pre-pulse laser to droplet constant or varied.

A further fabrication process may be carried out using the lithographic apparatus. The further fabrication process may comprise: providing a second patterning device for exposing a further substrate within the lithographical apparatus; and, adjusting the parameter to provide a predetermined dose profile associated with the second patterning device.

Other alternatives exist to providing an LLP source apparatus. For example, the source apparatus may include a Deep UV system in which a laser beam pointing techniques such as those described in US20040257547. The DUV source apparatus may include a 1-6 kHz Excimer laser to provide DUV radiation to a DUV scanner. The scanner may include beam pointing equipment which may be adjusted to provide dynamical dose profile adjustment during scanning. Hence, the parameter associated with an intensity distribution of radiation provided by a source apparatus to an optical input of the lithographic apparatus may comprise a beam pointing characteristic of a DUV source apparatus. In such a way the position/orientation of source radiation may be controlled based on a desired uniformity characteristics at the illuminator exit, e.g. the object/image plane within the lithographic apparatus.

A further alternative source apparatus or lithographic apparatus may include one or more filters. The one or more filters may comprise a spectral purity filter. The filters may be provided on a tilting mechanism so as to be tiltable during use. The filter may comprise a membrane or a membrane may be provided of other purposes other than filtering. Including a filter and/or membrane which is tiltable may be utilised to provide an off-centre/asymmetric radiation distribution in a dose profile which is perpendicular to a scan direction. Hence, the parameter used to set the dose profile may relate to the angle of tilt of a filter and/or membrane. The membrane may form part of the filter.

A spectral purity filter, SPF, is described in US2013010275. Such a filter would typically be placed in the lithographic apparatus close to its optical input. The SPF may comprise a membrane which may be oriented perpendicular to the optical axis of the radiation provide by the source. The source radiation may comprise a large angular range which may be symmetrical around the optical axis. When tilting the SPF around the y-axis an asymmetry of the range of the angle of incidence with respect to the SPF is created. Typically, the EUV radiation passing through the SPF would also have some intensity tilt. Hence, SPF tilt control has a similar effect as the tilt angle of the disc droplets. The tilting mechanism may be any suitable mechanism known in the art.

The dose profile adjustment methods described within this specification may be carried out using a lithographic apparatus LA similar to that described in relation to Figure 2. The lithographic apparatus LA may comprise: a source apparatus 20 for providing radiation to an optical input of the lithographic apparatus LA, wherein the lithographic apparatus LA is configured to scan the radiation across a patterning device in a direction of scanning, wherein the radiation has a dose profile along a direction perpendicular to the direction of scanning. However, the source apparatus 20 may be considered to be separate to the lithographic apparatus LA. The lithographic apparatus may include a processor configured to adjust a parameter associated with the source apparatus according to any of the methods described herein. The processer may be located in the source controller 60, or in a central computer system, CT, such as that shown in Figure 4.

The control of the parameter may be predetermined in accordance with a particular lithographic apparatus and/or fabrication process. The control may comprise one or more parameter settings. The parameter settings may form part of a configuration file. The configuration file may be provided to a lithographic apparatus and/or source apparatus such that the lithographic apparatus and/or the source apparatus may be configured according to the parameter settings held within the configuration file. For example, the configuration file may be provided to the central computer system CT or source apparatus controller 60 via a network connection, data signal or a network connection. The parameter settings may form part of a database or other similar computer readable format, as known in the art. Hence, an end user or customer may provide a fabrication process/recipe to the lithographic apparatus or source apparatus which comprises information relating to the desired behaviour of the lithographic apparatus or source apparatus.

Thus, a method may include providing a configuration file, the configuration file comprising at least one predetermined parameter setting associated with a lithographic apparatus or illumination source. The configuration file may form part of a carrier which stores or transmits the configuration file such that it can be uploaded to the lithographic apparatus or illumination source.

The lithographic apparatus may include an optical interface arranged to receive the radiation, e.g. the EUV light, outputted by the source apparatus. As described above, the radiation may have an asymmetric of off-centre intensity distribution. The dose or intensity profile may vary during the scanning (e.g. within a field size on the substrate).

The invention allows (at least too some extent) independent control of the dose and/or intensity profile along the direction of scanning and the dose and/or intensity profile along a direction perpendicular to said direction of scanning. To support this the lithographic apparatus may include a control interface arranged to receive parameters characterizing a desired dose and/or intensity profile adjustment across a substrate along both a scanning direction and a direction perpendicular to said scanning direction.

The method may be executed by a computer. Thus, a computer program may be provided which comprises instructions which, when executed on at least one processor, cause the at least one processor to control an apparatus to carry out any of the methods described herein. The carrier may be provided on a carrier containing. The carrier may be one of an electronic signal, optical signal, radio signal, or non-transitory computer readable storage medium.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

A list of numbered embodiments of the invention is given below.
1. A method for controlling a dose or intensity profile of a lithographic apparatus along a direction perpendicular to a direction of scanning across a patterning device, the method comprising:
   determining a parameter associated with an intensity distribution of radiation provided by a source apparatus to an optical input of the lithographic apparatus, wherein
   the determining of the parameter is at least based on a relation between the intensity distribution of the radiation at the optical input of the lithographic apparatus and the dose or intensity profile.
2. A method according to embodiment 1, wherein the source apparatus comprises a plasma light source in which a plurality of droplets of a material are converted in turn into a plasma to radiate light using an irradiation source, the method further comprising:
   adjusting the parameter to irradiate the plurality of droplets so as to produce a desired dose profile along a direction perpendicular to the direction of scanning.
3. A method according to embodiment 2, further comprising:
   irradiating the plurality of droplets along a first irradiation axis in turn with the irradiation source to provide a plurality of disc droplets; and,
   irradiating the plurality of disc droplets in turn along a second irradiation axis to provide a plasma and resultant radiant light.
4. A method according to embodiment 3, wherein the parameter relates to the position of the second irradiation axis relative to the position of the each of the plurality of disc droplets such that each of the plurality of disc droplets is irradiated along the second irradiation axis at an off-centre position of the disc droplets.
5. A method according to embodiment 3 or 4, wherein each disc droplet is tilted with respect to the second irradiation axis such that light radiated from the plasma has an intensity distribution to provide the desired dose profile.
6. A method according to embodiment 5, wherein the tilt of the each disc droplet is provided by irradiating each of the plurality of droplets along the first irradiation axis, wherein the first irradiation axis is tangentially inclined with respect to the droplet surface, the tangential inclination being predetermined to provide a desired dose profile.
7. A method according to embodiment 6, wherein the plurality of droplets are passed in series through the first irradiation axis along a path of travel and the tangential inclination is provided by irradiating the droplet at a predetermined position along the path of travel and the parameter relates to the irradiation to droplet position.
8. A method according to embodiment 7, wherein the first irradiation axis is fixed and the parameter is the timing of the irradiation relative to the droplet position.
9. A method according to embodiment 1 to 7, wherein the first irradiation axis is moveable and the parameter is the position of the irradiation axis relative to the droplet position.
10. A method according to any preceding embodiment, wherein the patterning device is predetermined to include higher dose areas and lower dose areas, and the dose profile is adjusted using the parameter to provide the higher dose areas and lower dose areas respectively.
11. A method according to any preceding embodiment, wherein the radiation is provided to a slit which extends in the direction perpendicular to the direction of scanning and wherein the parameter is adjusted whilst the slit is moved across the patterning device in the direction of scanning.
12. A method according to embodiment 11, wherein the parameter is adjusted to provide a predetermined dose profile for the scan.
13. A method according to any of embodiments 2 to 12, wherein the parameter is adjusted once for a series of the plurality of droplets, wherein the series is greater than two.
14. A method according to any of embodiments 2 to 13, wherein the intensity of the irradiating source is determined in accordance with the angle of incidence.
15. A method according to any of embodiments 4 to 14, wherein the angle of tilt is between plus or minus 5 degrees that of a nominal angle of tilt which provides a symmetric dose profile.
16. A method according to any of embodiments 2 to 15, wherein the second irradiation axis is plus or minus 10 microns that of a nominal droplet centre which provides a nominal dose profile at the time of irradiation.
17. A method according to any of embodiments 2 to 16, wherein the irradiation source comprises at least one laser.
18. A method according to any of embodiments 2 to 17, wherein the irradiation source comprises a first laser beam and a second laser beam.
19. A method according to any of embodiments 2 to 18, wherein the radiant light is EUV.
20. A method according to any of embodiments 2 to 19, wherein the droplet material comprises tin.
21. A method according to any of embodiments 2 to 20, wherein the plurality of droplets are provided with a frequency of between 40kHz and 100kHz.
22. A method according to any preceding embodiment, wherein the source apparatus provides an optical output having an off-centre intensity distribution.
23. A method according to any preceding embodiment, wherein the lithographic apparatus includes one or more moveable blocking element arranged to block and/or filter a portion of the dose profile or intensity profile.
22. A method according to any preceding embodiment, further comprising:
   providing a patterning device;
   providing a substrate for exposure in the lithographic apparatus;
   providing radiation from the source apparatus to the optical input of the lithographic apparatus in which the parameter has been adjusted to provide a predetermined dose profile associated with the patterning device;
   exposing the substrate to radiation from the source apparatus according to the predetermined dose profile.
23. A method according to embodiment 22, wherein exposing the substrate to radiation comprises scanning the substrate in a first direction and the method further comprises:
   adjusting the parameter during the scan in the first direction.
24. A method according to embodiment 23, further comprising:
   providing a second patterning device for exposing a further substrate within the lithographical apparatus;
   adjusting the parameter to provide a predetermined dose profile associated with the second patterning device.
25. A method according to embodiment 9 or 11 wherein the source apparatus comprises a laser, and the parameter relates to a beam pointing characteristic.
26. A method according to embodiment 25, wherein the lithography apparatus is a Deep UV apparatus.
27. A method according to any preceding embodiment, further comprising: providing a configuration file for use by the lithographic apparatus or source apparatus, wherein the configuration file comprises at least one predetermined parameter setting associated with a lithographic apparatus or source apparatus.
28. A lithographic apparatus comprising:
   a source apparatus for providing radiation to an optical input of the lithographic apparatus, wherein the lithographic apparatus is configured to scan the radiation across a patterning device in a direction of scanning, wherein the radiation has a dose profile along a direction perpendicular to the direction of scanning; and
   a processor configured to adjust a parameter associated with the source apparatus according to any of embodiments 1 to 27 to adjust the dose profile.
29. A computer program comprising instructions which, when executed on at least one processor, cause the at least one processor to control an apparatus to carry out the method according to any of embodiments 1 to 27.
30. A carrier containing the computer program of embodiment 27, wherein the carrier is one of an electronic signal, optical signal, radio signal, or non-transitory computer readable storage medium.
31. A method for controlling a dose profile of a lithographic apparatus along a direction perpendicular to a direction of scanning across a patterning device, the method comprising:
   determining a parameter associated with an intensity distribution of radiation provided by a source apparatus to an optical input of the lithographic apparatus
   wherein the parameter is determined at least partially based on a relation between the parameter and a characteristic of the radiation at an image and/or object plane of the lithographic apparatus.
32. A method according to embodiment 31, further comprising:
   monitoring the intensity distribution of radiation at the image and/or object plane of the lithographic apparatus.
33. A method according to embodiment 31 or 32, wherein the parameter is a parameter of the lithographic apparatus.
34. A method according to embodiment 33, wherein the lithographic apparatus comprises a tiltable membrane which is configurable to alter the intensity distribution, wherein the parameter relates to the angle of tilt of the tiltable membrane.
35. A method for controlling a dose profile of a lithographic apparatus along a direction perpendicular to a direction of scanning across a patterning device, the method comprising:
   determining a parameter associated with an intensity distribution of radiation provided by a laser produced plasma light source apparatus to an optical input of the lithographic apparatus, wherein the parameter adjusts the laser to droplet position within the source apparatus to provide an off-centre intensity distribution in the direction perpendicular to the direction of scanning.
36. A method according to embodiment 35, wherein parameter is related to the timing of a pre-pulse laser.
37. A method for controlling a dose profile of a lithographic apparatus along a direction perpendicular to a direction of scanning across a patterning device, the method comprising:
   determining a parameter associated with an intensity distribution of radiation provided by a source apparatus to an optical input of the lithographic apparatus;
   scanning the radiation across the patterning device in the direction of scanning; adjusting the parameter during the scan.
38. A method for controlling a dose profile across an exposure field of a lithographic apparatus, the method comprising:
   controlling the dose profile based on selecting an exposure field specific setting of a control parameter associated with a source providing radiation to the lithographic apparatus.
39. A source apparatus for providing radiation to a lithographic apparatus, wherein the source apparatus is configured to receive one or more settings of a parameter associated with a dose profile of the radiation, wherein the one or more settings are based on the parameter as determined using the method of any of embodiments 1 to 27 or 31 to 38.
40. A source apparatus according to embodiment 39, wherein the one or more settings of the parameter provide an off-centre dose profile.
41. A lithographic apparatus having an optical interface arranged to receive a radiation output from the source apparatus of embodiment 39, wherein the radiation output has a far-field asymmetric intensity distribution.
42. A lithographic apparatus including a control interface arranged to receive parameters characterizing a dose and/or intensity profile adjustment across a patterning device along a direction of scanning and a direction perpendicular to the direction of scanning.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for controlling a dose or intensity profile of a lithographic apparatus along a direction perpendicular to a direction of scanning across a patterning device, the method comprising:
determining a parameter associated with an intensity distribution of radiation provided by a source apparatus to an optical input of the lithographic apparatus, wherein
the determining of the parameter is at least based on a relation between the intensity distribution of the radiation at the optical input of the lithographic apparatus and a characteristic of the dose or intensity profile.

2. A method as claimed in claim 1, wherein the source apparatus comprises a plasma light source in which a plurality of droplets of a material are converted in turn into a plasma to radiate light using an irradiation source, the method further comprising:
adjusting the parameter to irradiate the plurality of droplets so as to produce a desired dose profile along a direction perpendicular to the direction of scanning.

3. A method as claimed in claim 2, further comprising:
irradiating the plurality of droplets along a first irradiation axis in turn with the irradiation source to provide a plurality of disc droplets; and,
irradiating the plurality of disc droplets in turn along a second irradiation axis to provide a plasma and resultant radiant light.

4. A method as claimed in claim 3, wherein the parameter relates to the position of the second irradiation axis relative to the position of the each of the plurality of disc droplets such that each of the plurality of disc droplets is irradiated along the second irradiation axis at an off-centre position of the disc droplets.

5. A method as claimed in either of claims 3 or 4, wherein each disc droplet is tilted with respect to the second irradiation axis such that light radiated from the plasma has an intensity distribution to provide the desired dose profile.

6. A method as claimed in claim 5, wherein the tilt of the each disc droplet is provided by irradiating each of the plurality of droplets along the first irradiation axis, wherein the first irradiation axis is tangentially inclined with respect to the droplet surface, the tangential inclination being predetermined to provide a desired dose profile.

7. A method as claimed in claim 6, wherein the plurality of droplets are passed in series through the first irradiation axis along a path of travel and the tangential inclination is provided by irradiating the droplet at a predetermined position along the path of travel and the parameter relates to the irradiation to droplet position.

8. A method as claimed in claim 7, wherein the first irradiation axis is fixed and the parameter is the timing of the irradiation relative to the droplet position.

9. A method as claimed in any of claims 3 to 7, wherein the first irradiation axis is moveable and the parameter is the position of the irradiation axis relative to the droplet position.

10. A method as claimed in any preceding claim, wherein the patterning device includes higher dose areas and lower dose areas, and the parameter is adjusted to provide a dose profile compatible with the higher dose areas and lower dose areas.

11. A method as claimed in any preceding claim, wherein the radiation is provided to a slit which extends in the direction perpendicular to the direction of scanning and wherein the parameter is adjusted whilst the slit is moved across the patterning device in the direction of scanning.

12. A method as claimed in any preceding claim, further comprising: providing a configuration file for use by the lithographic apparatus or source apparatus, wherein the configuration file comprises at least one predetermined parameter setting associated with a lithographic apparatus or source apparatus.

13. A lithographic apparatus comprising:
a source apparatus for providing radiation to an optical input of the lithographic apparatus, wherein the lithographic apparatus is configured to scan the radiation across a patterning device in a direction of scanning, wherein the radiation has a dose profile along a direction perpendicular to the direction of scanning; and
a processor configured to adjust a parameter associated with the source apparatus according to any of method claims 1 to 12 to adjust the dose profile.

14. A lithographic apparatus including a control interface arranged to receive parameters characterizing a dose and/or intensity profile adjustment across a patterning device along a direction of scanning and a direction perpendicular to the direction of scanning.

15. A computer program comprising instructions which, when executed on at least one processor, cause the at least one processor to control an apparatus to carry out the method according to any of claims 1 to 12.
